# EUROPEAN PATENT SPECIFICATION

(11) **EP 2 138 222 B1**
(45) Date of publication and mention of the grant of the patent: **08.06.2011**
(21) Application number: 09386016.1
(22) Date of filing: 25.06.2009
(51) Int. Cl.: B01D 71/02, B01D 67/00, B01D 65/10

(54) **Method for pore size modification of an inorganic membrane by chemical vapor infiltration**
Methode zur Modifizierung der Porengrösse inorganischer Membranen mit Hilfe von chemischer Gasphaseninfiltration
Methode de modification de la taille des pores par infiltration chimique en phase vapeur

(30) Priority: 27.06.2008 GR 20080100438
(43) Date of publication of application: 30.12.2009
(73) Proprietor: Sakellaropoulos, George P., 54006 Thessaloniki (GR); Kalidis, Sotiris, 54006 Thessaloniki (GR); Koutsonikolas, Dimitris, 54006 Thessaloniki (GR)
(72) Inventor: Sakellaropoulos, George P., 54006 Thessaloniki (GR); Kalidis, Sotiris, 54006 Thessaloniki (GR); Koutsonikolas, Dimitris, 54006 Thessaloniki (GR)

(56) References cited:
- WO-A1-96/01682
- US-A- 5 683 797
- US-A- 5 753 121
- US-A1- 2007 013 094

## Description

### Technical field of the invention

Gas separation is one of the most important processes in chemical industries. Some typical examples are: the separation of oxygen - nitrogen mixture for the production of pure oxygen or pure nitrogen, the separation and recovery of hydrogen from hydrocarbons in refineries, the removal of carbon dioxide and hydrogen sulfide from natural gas, hydrogen - nitrogen separation in ammonia plants, carbon dioxide - nitrogen separation for controlling greenhouse gases emissions, etc.

In the last few years the use of membranes as an alternative gas separation technology has been examined. The main advantages of membranes over conventional technologies, such as cryogenics or absorption, are the lower energy demand and the higher selectivities of membranes. Up to now only polymeric membranes have found industrial applications in some gas separation processes, such as oxygen separation from air, and natural gas cleaning. All these processes take place at low temperatures (up to 70 °C) due to thermal stability problems of polymeric materials at higher temperatures. Many gas separation processes, such as H₂ recovery in Integrated Gasification Combined Cycle plants, would be more economic if they would take place at higher temperatures where polymeric membranes can not be used. For this reason, research on inorganic membranes for use in gas separation applications has intensified. These membranes can be used at high temperatures (up to 650 °C) and harsh environments where polymeric membranes fail. Also, inorganic membranes can be sterilized with steam or chemicals for biological, pharmaceutical or foods applications.

A special category of inorganic membranes which attracts great interest is the microporous membranes, namely membranes with pore size less than 2 nm, according to IUPAC. These membranes usually have an asymmetric structure and consist of a macroporous support (pore size greater than 50 nm), which provides mechanical strength, a mesoporous intermediate layer (pore size between 2 and 50 nm) for gradual pore size reduction and a microporous top layer, which is responsible for the separation. Typical gas separation applications where microporous membranes can be used include hydrogen and helium recovery from mixtures with larger gas molecules like carbon dioxide, carbon monoxide, nitrogen sulphur hexafluoride, methane and other hydrocarbons, etc. Also, the use of such membranes in membrane reactors seems attractive for the separation-removal of a reaction product through the membrane, in order to enhance conversion. Typical examples of such reactions are the steam reforming of methane, the water gas shift reaction, the decomposition of hydrogen sulphide and ammonia, the dehydrogenation and controlled partial oxidation of hydrocarbons and generally all reactions which are thermodynamically limited.

### Technical problem to solve

An important drawback of microporous inorganic membranes is the difficulty to produce large membrane areas without defects in their structure, which are necessary for industrial scale applications. Moreover, defects can be formed on the top layer of the membranes during their utilization. As a defect we can consider any crack, pinhole or even a pore on the selective top layer of the membrane, with size larger than that required for a specific separation. For example, the separation of hydrogen (kinetic diameter 0.289 nm) from nitrogen (kinetic diameter 0.364) needs pores with diameters of 0.289-0.364 nm. In this case, the existence of even a small number of pores with diameter larger than 1 nm on the membranes top layer can cause a significant reduction in the selectivity and therefore in the performance of the specific separation. The consistent and reproducible development of membranes with such small pore sizes, is not possible with current available techniques at relative low temperatures (<300 °C).

### Background of the invention

Most of the gas separation ceramic membranes consist of a macroporous α-alumina support and successive layers of γ-alumina and/or silica for pore size reduction. Especially silica is used widely in one ore more successive microporous top layers. There are two different methods for the preparation of microporous and nanoporous silica layers on a support:
- The sol-gel method
- The chemical vapor deposition / chemical vapor infiltration (CVD / CVI) method

The sol gel method is used more often because of its simplicity. Silica membranes are prepared with this method by a simple dipping or casting of the support in a special sol of the silica source, followed by drying and calcination steps. A drawback of this method is the high probability for defect formation during the preparation steps, especially when large membrane areas have to be prepared. Therefore, the best commercial membranes prepared by this method have pore sizes larger than 2-5 nm. Apart from alumina and silica membranes, the sol-gel method has also been used for the preparation of titania and zirconia membranes, by using the respective titanium and zirconium organometallic compounds [1,2]. These membranes are mainly used for nanofiltration, ultrafiltration and microfiltration of liquids, thus they have pore sizes of about 2 nm - 1 µm. We do not know of any such membranes with smaller pore sizes.

An alternative technique for the preparation of microporous silica membranes, with pore size less than 2 nm, is the CVD or CVI method. According to this method two gaseous components, one which acts as a silica source (e.g. tetraethyl orthosilicate, tetramethyl orthosilicate, silicon tetrachloride, silicon tetrahydride, silicon tetraacetate etc.) and an oxidizing agent (e.g. oxygen, steam, ozone), are fed on the same or the opposite side of the membrane at a specific pressure, temperature and flow rate. Depending on the process conditions, the reactants are met somewhere within the pores and they react creating deposits on the pores walls. Gavalas an co-workers studied extensively the CVD method for the preparation of silica membranes and obtained two relevant patents [3,4]. These patents describe the application of the CVD method for the preparation of a silica layer on alumina and porous Vycor glass substrates. Many compounds of the general type RXₙ or SiHₙCl₄₋ₙ were proposed as silica sources, while oxygen or steam was used as oxidizing agents. However, the temperatures suggested for application of these methods were relative high (>400 °C). In addition, three more patents [5-7] report a method for the development of silica membranes onto mesoporous supports by thermal pyrolysis of a silica source compound at high temperatures (>500 °C). Finally, another US patent [8] refers to a method for the preparation of carbon-based materials (e.g. carbon membranes) and includes many methods for the post treatment of the abovementioned materials. One of the post treatment methods proposed in order to modify the surfaces or pore structures and the properties of the materials, is a state of the art CVD technique. In this method the precursors are fed with an inert gas and/or hydrogen to the carbon materials at temperatures between 200 - 2000 °C, preferably 500 - 1500°C and most preferably 700 - 1300 °C. Nevertheless, the abovementioned patent does not contain detailed information for the application of the CVD process at low temperatures and also does not contain details for the state of the art CVD processes and their effectiveness. According to our knowledge there are no data testifying the effective application of a CVD method to membranes at temperatures <400 °C, with the use of a silica precursor and an inert gas and/or hydrogen, in order to upgrade their performance.

Most literature studies related to the CVD method refer to the use of mesoporous or macroporous supports at high temperatures. Recently, the application of the CVD method was examined at high temperatures (600 °C) for the modification of microporous silica membranes, prepared by the sol-gel method [9]. The researchers concluded that the combination of the two techniques (sol-gel and CVD) can lead to the preparation of high performance membranes.

At this point it should be emphasized that sealing of ceramic membranes in contact with metal parts at high temperatures is a major problem. The available technologies allow an effective sealing of ceramic with metals without leaks at temperatures up to 300 °C, by using commercial polymeric o-rings. Sealing at higher temperatures have been performed at lab scale, but their potential application for commercial use of the membranes is very difficult and still uncertain. To apply the CVD method at lower temperatures ozone is often used as an oxidizing agent The use of ozone has been proposed in a recent patent [10] for the modification of membrane pore sizes, by the CVD method at temperatures of 20-300 °C. However ozone is considered to be very toxic, and requires the use of an ozone generator; therefore, it increases the complexity of the process and the preparation cost of the membranes. Furthermore, special provisions are needed in order to avoid ozone leaks and to create a safe working environment.

Our method differs from other state of the art methods, since the conditions used in this work, as described below, allow the easy application of the method at low temperatures, with inexpensive and easy to handle materials, in order to repair defects and modify the pore size of microporous membranes. The serious difficulties encountered with all other state of the art methods used so far for the production of microporous membranes, is further supported by the unavailability of commercial microporous membranes with pores less than 2 nm, even for small scale applications.

### Summary of the invention

The present invention refers to a CVI method which takes place at relative low temperatures (200 - 300 °C), with the use of tetramethyl orthosilicate (or similar organic compounds of silicon, titanium, zirconium or aluminum) and oxygen (or mixtures of oxygen with an inert gas, e.g. air) as reactants and aims to pore size reduction and/or to defect repair of microporous membranes.

### Advantages of the invention

The present invention describes a CVI method which is easier to be applied than other methods referred in the literature, since requires the adjustment of process parameters (pressure, gas flow rate) only in the feed side. In contrast to the proposed method, most other techniques require accurate control of process parameters on both sides of the membrane in order to achieve the proper point within the membrane where reactants are met to form deposits. Furthermore, the present method is effective at relative low temperatures, where it is possible to apply the current available sealing technologies in an industrial plant. This technique can also be used for in situ repair of membranes which may have created a microcrack, without the need of disassembly of the membrane module. Membranes with a thin, microporous top layer are ideal substrates for application of the method even at low temperatures, using economical and non toxic reactants.

### Description of one application of the invention, with remarks to the figures

The invention is described below, with the use of an example and with remarks to the attached figures. The membrane which is modified in the present example is an asymmetric silica hollow fiber membrane (3mm OD, 2mm ID, 17 cm length) which is produced commercially by Hyflux CEPAration (The Netherlands). Silica has been deposited on this initial membrane, using the new proposed CVI technique.

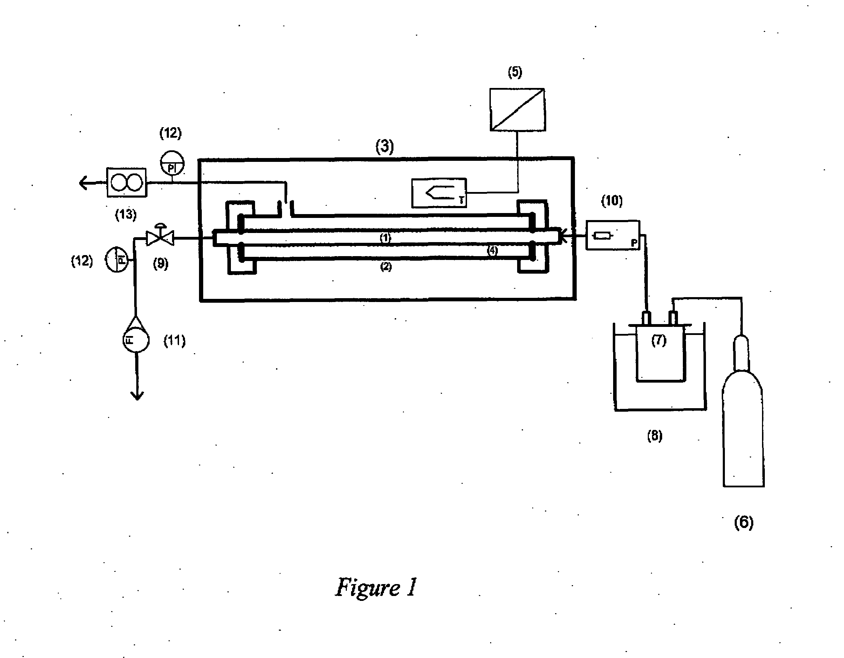

Figure 1 shows the process flow diagram. The membrane (1) to be modified by the present method is placed in a metallic cell (2) and then into a furnace (3). The sealing between the cell and the membrane is achieved using attained thermal resistant (>300 °C) O-rings (4) (Parofluor Ultra procured by Parker). The furnace temperature and heating rate are controlled by a controller (5). The heating rate must be low (1-10 °C/min) in order to avoid thermal stresses of the membrane. When the desirable temperature is reached, oxygen gas (6) is fed in a bubbler which contains the silica source (7), where it is enriched with vapors of the specific component (TEOS in the present example), and then it is fed to the membrane side on which the microporous layer is located (lumen side). The bubbler which contains the silica source is placed in a heating bath (8) for temperature control in the range of 20-90 °C (60 °C in the present example). When the temperature of the bubbler is higher than the ambient temperature all gas lines of the process should be heated in order to avoid condensation of vapours. Oxygen flow is controlled by a regulating valve (9) and a gas flowmeter (10), at the exit of the cell, at 10-100 stdcc/min (50 stdcc/min in the present example) in order for the gas to be saturated with vapours. The feed gas pressure is controlled with a pressure regulator (11) at 1-20 psig (10 psig in the present example), while the permeate exits at ambient pressure. The pressure difference on the two sides of the membrane is measured with pressure indicators (12). This pressure difference creates a flow through the pores of the membrane, which is measured with a bubblemeter (13). The flow rate decreases with time as the pore size decreases and/or the top layer's defects are repaired. The flow rate reduction and its subsequent stabilization at a new low value is an indication of completion of the process. Typical reaction times vary between 2-12 h (6 h in the present example).

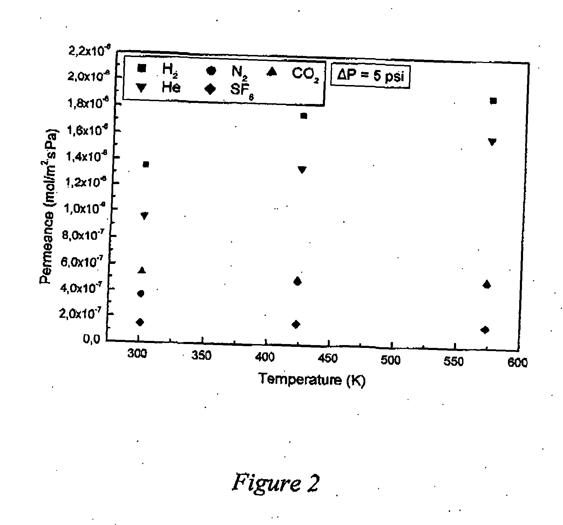

The effectiveness of pore size reduction and/or defect repair can be examined by measuring the permeance of the membrane before and after the application of the proposed CVI technique. Figure 2 shows the permeance of several gases (He, H₂, CO₂, N₂, SF₆) in the silica membrane before its modification. In a microporous membrane the gas transport mechanism is activated diffusion. Therefore, the permeance of gases is determined by their size (smaller molecules have higher permeance values) and increases exponentially with temperature. In a mesoporous membrane, gas transport takes place by Knudsen diffusion and convective flow. In this case the permeance of gases depends mainly on their molecular weight (lighter gases have higher permeance values) and decreases with temperature. In the specific membrane, the permeance of gases before modification by the proposed technique, the permeance of the gases increases slightly with temperature and depends mainly on the molecular weight of the gases. Moreover, the ideal selectivity of the non-modified membrane in several gas pairs (defined as the ratio of two gas permeances) is close to the theoretical Knudsen value. This behaviour indicates that this membrane contains micropores along with mesopores. These mesopores can be considered as a number of defects which affect the performance of the membrane.

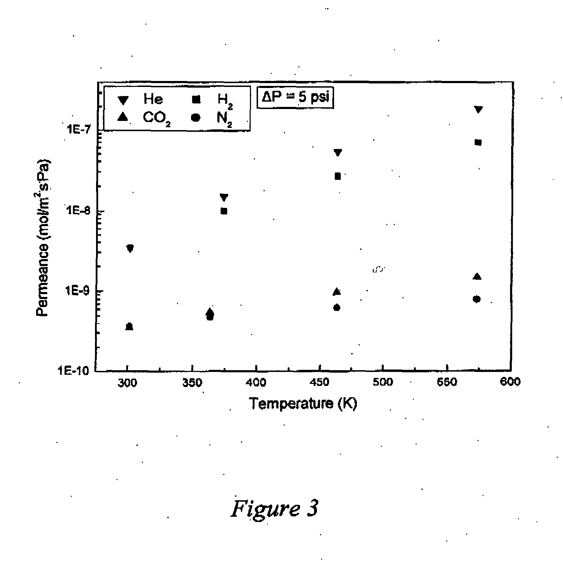

Figure 3 shows the permeance of the same gases in the silica membrane after the present CVI modification. The permeance of the gases increases exponentially with temperature and the selectivity of the membrane increased significantly. This behavior is indicative of the activated diffusion gas transport mechanism, which is dominant in the micropores. It is worth noting that SF₆, a molecule with a large kinetic diameter (0.55 nm), can not permeate at all through the modified membrane. This behaviour indicates that all pores of the modified membrane are smaller than 0.55 nm and therefore all defects have been repaired.

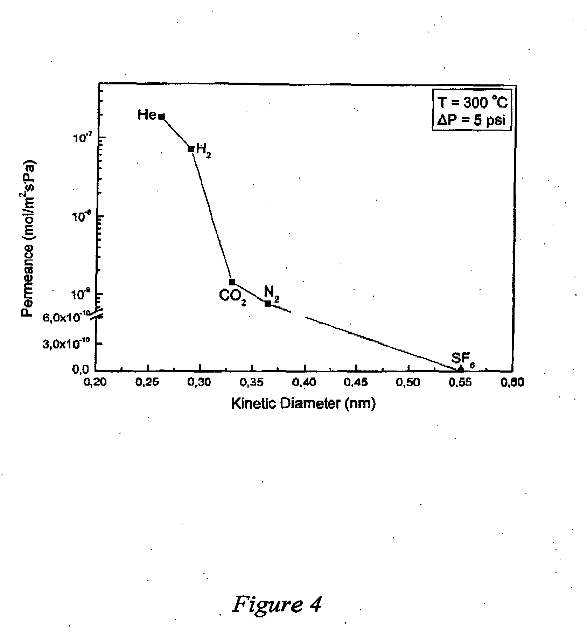

Figure 4 shows the permeance of gases in the CVI modified membrane with respect to the kinetic diameter of the molecules. It is evident that the permeance of the gases depends exclusively on their kinetic diameter. This confirms the microporous structure of the membrane.

Table 1 shows a summary of the permeance and selectivity values of the membrane at 300 °C before and after the CVI modification.

**Table 1: Permeance and selectivity values at 300 °C and ΔP = 5 psi in silica membranes before and after the CVI modification**

| | Permeance x 10⁸ (mol/m² sPa) | | | | | Selectivity | | | | |
|---|---|---|---|---|---|---|---|---|---|---|
| | H₂ | He | N₂ | CO₂ | SF₆ | H₂/N₂ | H₂/CO₂ | H₂/SF₆ | CO₂/N₂ | He/N₂ |
| Initial membrane | 190 | 160 | 50 | 51 | 16 | 3.8 | 3.7 | 11.9 | 1 | 3.2 |
| Modified membrane | 7.1 | 19 | 0.078 | 0.143 | - | 91 | 50 | ∞ | 1.8 | 244 |

Exposure of silica membranes to water vapors at high temperatures can cause considerable changes in their surface structure. These changes may also cause severe changes in the gas permeance of the membranes. Surface hydroxyl groups of the membranes react, as shown below, forming silicon badges:

-SiOH + -SiOH → Si-O-Si + H₂O

The CVI-modified membranes of the present invention were checked for their stability in water vapors at 300 °C. Exposure of the modified membranes to a gas stream saturated with water vapors for 24 h, resulted in some gas permeance changes which caused selectivity reduction of no more than 20%. Further exposure of the membranes to water vapors for 60 h did not cause any additional changes. After exposure of the membranes to water vapors the proposed CVI technique was applied again and membrane selectivity was restored to its initial level.

The application of the proposed CVI method described in the above example is not limited only to these specific membranes. The method can be applied to silicon carbide, alumina, zirconia, titania, zeolite or carbon membranes, following the same procedure. These membranes can be tubular (of any dimensions with the selective layer to be located in the inner or the outer surface), planar or of any other geometry. Moreover, the same method can be applied using any other silica source like tetramethyl orthosilicate, silicon tetrachloride, silicon tetrahydride, silicon tetraacetate etc. Similar compounds of aluminum (e.g. aluminum alkoxides like aluminum tributoxide, aluminum triacetate etc.), titanium (e.g. titanium alkoxides like titanium tetra-isopropoxide, titanium tetrachloride etc.) or zirconium (e.g. zirconium alkoxides like zirconium tetra-isopropoxide etc.) can also be used for the deposition of alumina, titania or zirconia respectively. Finally, as an oxidizing agent instead of O₂ a mixture of O₂ with an inert gas e.g. nitrogen (air or any other composition of oxygen-nitrogen) can also be used.

### Application fields of the microporous membranes

These specific membranes can be used in many gas separation applications in the chemical industry. Examples of such separations are the separation of hydrogen from carbon dioxide in gasification processes, the separation of hydrogen from carbon monoxide for adjusting their ratio in synthesis gas, the separation and recovery of hydrogen from nitrogen in ammonia plants, the separation of hydrogen from several hydrocarbons in refineries, the recovery of helium from natural gas, the recovery of sulfur hexafluoride which is used as a dielectric material in power plants etc. To demonstrate such an application, a gas separation is estimated for a gas mixture consisting of 52% H₂, 37% CO₂ and 11 % N₂ at 15 bar (a typical gas mixture in solid fuel gasification plants). Using the CVI-modified membrane permeances reported in Table 1, we can estimate that 80% hydrogen recovery can be achieved, with 95% purity. In contrast, current state of the art membranes before modification would not achieve more than 70% purity. This recovery level of high purity hydrogen renders such modified membranes very attractive for application in gasification technologies in integrated cycles, and in new cycles with H₂-O₂ fuel cells, with very important environmental impact and improved energy efficiency.

Another application field for these membranes is the pervaporation applications. Examples of such processes are the dehydration of many industrial solvents like alcohols, glycols, carboxyl acids, esters, ethers, ketones, amines, cyanide compounds, halogen hydrocarbons etc. as well as azeotropic mixtures. There are many references in the literature for the application of inorganic membranes in such processes [11]. However, all state of the art commercial inorganic membranes can not achieve pore sizes less than 2-10 nm, and their selectivity does not permit their economic application. With the proposed technique the pore sizes of the ceramic membranes can be controlled to 0.5-1 nm, with obvious improvement in separation selectivity, as in the case of the gas separation applications.

In addition, microporous and can be used in filtration applications (mainly in nanofiltration, where pore sizes smaller than 2 nm are necessary, a size which can not be achieved by other techniques). Examples of such processes are the removal of ions (e.g. chromium, arsenic etc.) from potable and industrial water or from liquid wastes. Analytical descriptions of polymeric and inorganic membrane applications in such processes can be found in the literature [12]. The proposed CVI technique allows the preparation and repair of membranes with the required pore sizes (below 2 nm).

Finally, the microporous and can be used in membrane reactors in order to shift the equilibrium and increase the yield of several reactions. Examples of such reactions are the steam reforming of methane for hydrogen production, the water gas shift reaction for hydrogen production, the dehydrogenation or selective partial oxidation reactions of hydrocarbons, the decomposition of hydrogen sulfide and ammonia in coal gasification processes for hydrogen recovery and gas cleaning, etc. In these processes, one of the reaction products diffuses selectively through the membrane and causes a shift of the equilibrium, thereby increasing the conversion of the reactants. As an example we can report the decomposition of ammonia in a coal gasification stream. Using an appropriate computational model we can calculate that the maximum conversion in a conventional PER reactor is 54%, while in a membrane reactor (using a membrane with the abovementioned properties) the maximum conversion is 98%, at 600 °C and 15 bar.

### REFERENCES

[1] R.R. Bhave, Inorganic membranes - synthesis characteristics and applications, Chapman and Hall, New York, NY (1991).
[2] K. Li, Ceramic membranes for separation and reaction, John Wiley & Sons, West Sussex, England (2007).
[3] G.R. Gavalas, C.E. Megiris, Synthesis of SiO₂ membrane on porous support and method of use of same, US Patent 4902307, 1990.
[4] G.R. Gavalas, S.W. Nam, M. Tsapatsis, S. Kim, Method for forming H₂. permselective oxide membranes, US Patent 5453298, 1995.
[5] S. Akiyama, H. Anzai, S. Morooka, H. Maeda, K. Kusakabe, Hydrogen separation membrane and process for producing the same, US Patent 5827569, 1998.
[6] T.S. Oyama, A.K. Prabhu, Hydrogen-selective silica based membranes, US Patent 6527833,2003.
[7] S.T. Oyama, L. Zang, D. Lee, D.S. Jack, Hydrogen-selective silica-based membrane, US Patent 6854602, 2005.
[8] N. Bischofsberger, A. Ban, B. Mayer, D. Goldmann, J. Rathenow, S. Asgari, Method for the preparation of porous, carbon-based material, US Patent 2007/0013094 A1, 2007:
[9] S. Gopalakrishnan, Y. Yoshino, M. Nomura, B. N. Nair, S-1. Nakao, A hybrid processing method for high performance hydrogen-selective silica membranes, J. Membrane Sci., 297 (2007) 5-9.
[10] J.A. McHenry, H.W. Deckman, E.W. Corcoran, F.W. Lai, H. Witzke, Membrane reparation and pore size reduction using interfacial ozone assisted chemical vapor deposition, International Patent WO9501682, 1996.
[11] S. Sommer, T. Melin, Performance evaluation of microporous inorganic membranes in the dehydration of industrial solvents, Chem. Eng. Proc., 44 (2005) 1138-1156.
[12] R.W. Baker, Membrane technology and applications, John Wiley & Sons, West Sussex, England (2004).

## Claims

1. A method for pore size modification and defect repair in microporous inorganic membranes of any geometry including planar, tubular and hollow fibers in order to become entirely microporous, with pore sizes of 0.2-2 nm by applying a chemical vapor infiltration (CVI) technique in which an organosilicon compound, an organometallic compound of silicon, a silane, a mixture of these or the corresponding compounds of aluminum, titanium and zirconium, and O₂ or a mixture of O₂ with an inert gas, (e.g. nitrogen) are fed simultaneously on the side of the membrane where the selective microporous layer is located. The membrane is heated at 200-300 °C, where the reaction of the two components takes place on the surface and in the pore walls, and creates deposits which reduce the pore size.

2. A method according to claim 1 where the microporous inorganic membrane is selected from a silica, silicon carbide, alumina, zirconia, titania, zeolite or carbon membrane.

3. A method according to claims 1-2 which is used for increasing the separation selectivity of microporous and nanoporous inorganic membranes.

4. A method according to claims 1-2 for in situ repair of inorganic industrial membranes, without disassembling them, in order to restore their separation selectivity if any microcracks were formed during their operation.

## Patentansprüche

1. Eine Methode zur Porengrößenmodifizierung und Defektenreparation von mikroporösen anorganischen Membranen jeder möglichen Geometrie einschließlich ebenen, röhrenförmigen und hohlen Fasern, so dass diese vollständig mikroporös mit einer Porengröße von 0.2-2 nm werden. Dies wird zustande gebracht durch aufwenden einer chemischen Dampf-Filtration Methode (CVI) bei der eine Siliziumorganische Verbindung, eine Silizium Metallorganische Verbindung, ein Silan, ein Gemisch von diesen oder entsprechenden Verbindungen von Aluminium, Titanium und Zirkonium und O₂ oder ein Gemisch von O₂ mit einem Inertgas (z.B. Stickstoff) gleichzeitig auf der Seite der Membran, wo sich die selektive mikroporöse Schicht befindet zugeführt werden. Die Membran wird auf 200-300 °C erhitzt und bei dieser Temperatur findet die Reaktion der beiden Komponenten auf der Öberflache und in den Porenwänden statt, dabei entstehen Ablagerungen, welche die Porengröße verkleinern.

2. Eine Methode gemäß Anspruch 1 bei der eine mikroporöse Membran aus den Materialien Silizium, Siliziumkarbide, Aluminium, Zirkonium, Titanium, Zeolith oder Kohlenstoff ausgesucht wird.

3. Eine Methode gemäß Anspruch 1 und 2 zur Steigerung der Trennungsselektivität von mikroporösen und nanoporösen anorganischen Membranen.

4. Eine Methode gemäß Anspruch 1 und 2 für die vor Ort Reparatur von anorganischen industriellen Membranen ohne diese zu zerlegen, um deren Trennungsselektivität wiederherzustellen wenn jegliche Mikrorisse während des Vorgangs vorgekommen sind.

## Revendications

1. La méthode pour la modification de la dimension du pore et la réparation de la defecience dans les membranes inorganiques et microporeuses de toute géométrie en comprenant plan, tubulaire et fibre creux, de sorte que les membranes deviendront completemet microporeuses, avec une dimension de pores 0.2-2 mn. Cela c'est fait par la technique de l'infiltration vapeur chemicque (CVI), selon la quelle un composant organique siliceux, un hydrure du silicium, une combinaison de ceux, ou les composants correspondants à l' aluminium, titane et zircon et O₂ ou un mixture du O₂ avec un gaz inerte (azote), seront simultanément importés sur la partie de la membrane, ou la couche sélective microporeuse a été soutenue. La membrane se chauffe aux 200-300 °C, et la réaction des deux composants se passe sur la surface et dans les parois du pore; ansi des dépositions qui réduisent la dimension du pore sont produits.

2. La méthode en accord avec la demande 1 à laquelle la membrane inorganique et microporeuse est sellectionée par le silicate, le carbure du silicium, l'aluminium, le titane, la zeolite ou la membrane du carbone.

3. La méthode en accord avec les demandes 1-2, laquelle est utilisée afin d'augmenter la séparation sélective des membranes microporeuses et nano poreuses inorganiques.

4. La méthode en accord avec les demandes 1-2, afin de réparer des membranes inorganiques industrielles sur place, sans les désassembler, double, et restaurer leurs séparation sélectives, si des imperfections ont été formées pendant l' opération.
